(19) Europäisches Patentamt
European Patent Office
Office européen des brevets

(11) **EP 4 321 884 B1**

(12) **EUROPEAN PATENT SPECIFICATION**

(45) Date of publication and mention
of the grant of the patent:
**16.07.2025  Bulletin 2025/29**

(21) Application number: **22884120.1**

(22) Date of filing: **21.10.2022**

(51) International Patent Classification (IPC):
*G01R 31/367* (2019.01)     *G01R 31/392* (2019.01)
*G01R 31/36* (2020.01)        *G01R 31/3842* (2019.01)
*G01R 19/165* (2006.01)      *G01R 31/396* (2019.01)
*G06N 20/00* (2019.01)       *G06N 3/09* (2023.01)

(52) Cooperative Patent Classification (CPC):
**G01R 31/367; G01R 31/3842; G01R 31/392;
G01R 31/396; G06N 3/09;** G06N 3/044;
G06N 3/0464; Y02E 60/10

(86) International application number:
**PCT/KR2022/016209**

(87) International publication number:
**WO 2023/068899 (27.04.2023 Gazette 2023/17)**

(54) **APPARATUS AND METHOD FOR DETECTING LATENT DEFECTIVE CELL IN BATTERY PACK**

VORRICHTUNG UND VERFAHREN ZUM ERFASSEN EINER LATENTEN DEFEKTEN ZELLE IN
EINEM BATTERIEPACK

APPAREIL ET PROCÉDÉ POUR DÉTECTER UNE CELLULE DÉFECTUEUSE LATENTE DANS UN
BLOC DE BATTERIES

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **22.10.2021  KR 20210142202**

(43) Date of publication of application:
**14.02.2024   Bulletin 2024/07**

(73) Proprietor: **LG Energy Solution, Ltd.**
**Seoul 07335 (KR)**

(72) Inventors:
• **LEE, Kyu-Chul**
**Daejeon 34122 (KR)**
• **JANG, Tae-Hyeok**
**Daejeon 34122 (KR)**
• **KIM, Cheol-Taek**
**Daejeon 34122 (KR)**
• **CHOI, Jee-Soon**
**Daejeon 34122 (KR)**

(74) Representative: **Plasseraud IP**
**104 Rue de Richelieu
CS92104
75080 Paris Cedex 02 (FR)**

(56) References cited:
WO-A1-2020/240324     JP-A- 2019 521 491
KR-A- 20200 119 383     KR-A- 20200 119 383
KR-A- 20210 016 154     KR-A- 20210 116 801
US-A1- 2020 081 070

**Description**

TECHNICAL FIELD

The present disclosure relates to an apparatus and method for detecting a latent defective cell in a battery pack, and more particularly, to an apparatus and method for detecting a latent defective cell by statistically analyzing differences between measured values and predicted values of voltage behaviors of cells during the charging of a battery pack.

BACKGROUND ART

As opposed to non-rechargeable primary batteries, rechargeable secondary batteries have a wide range of applications including small high-tech electronic devices such as smart phones, laptop computers or tablet computers as well as electric vehicles and energy storage systems (ESSs).

Since they can be used in a wide range of applications as described above, secondary batteries provide efficiency and convenience, but nevertheless, when overheated, they have explosion or fire risks due to high energy density.

In particular, recently, fire accidents caused by battery explosion aggravate concerns in the secondary battery market, and accordingly there is an urgent need to ensure safety of secondary batteries. US2020/081070 A1 relates to estimation of battery characteristics including State-of-Charge (SOC) and State-of-Health (SOH) using artificial neural networks.

DISCLOSURE

Technical Problem

The present disclosure is designed under the above-described background, and therefore the present disclosure is directed to providing an apparatus and method for detecting a latent defective cell among cells in a battery pack during the charging of the battery pack to improve safety of the battery pack.

Technical Solution

To solve the above-described technical problem, an apparatus for detecting a latent defective cell in a battery pack according to an aspect of the present disclosure includes a voltage measurement unit, a current measurement unit and a temperature measurement unit to measure a voltage, a current and a temperature of first to N-th cells included in the battery pack during charging of the battery pack, respectively, and a control unit operably coupled to the voltage measurement unit, the current measurement unit and the temperature measurement unit.

During the charging of the battery pack according to a charging profile having a plurality of charging ranges, for each of the first to N-th cells in each charging range, the control unit may be configured to acquire first cell voltage time-series data through the voltage measurement unit in a former part of the charging range. Additionally, the control unit is be configured to determine predicted cell voltage time-series data in a latter part of the charging range by applying a deep learning model to the first cell voltage time-series data. Additionally, the control unit is configured to acquire second cell voltage time-series data through the voltage measurement unit in the latter part of the charging range, and determine an error between the second cell voltage time-series data and the predicted cell voltage time-series data. Additionally, the control unit is configured to detect any cell having a larger error than other cells in at least one of the charging ranges as the latent defective cell.

According to an aspect, the control unit may be configured to, for each of the first to N-th cells, determine a maximum difference between the second cell voltage time-series data and the predicted cell voltage time-series data as the error for each charging range.

Additionally, the control unit may be configured to determine a first average and a first standard deviation of the error of the first to N-th cells for each charging range; determine "(the error - the first average)/the first standard deviation" corresponding to a first standardized value of the error of each of the first to N-th cells for each charging range, and detect any cell in which the first standardized value is larger than a first threshold in at least one of the charging ranges as the latent defective cell.

Preferably, the deep learning model may be pre-trained, using the first cell voltage time-series data and the second cell voltage time-series data of first to m-th training cells respectively measured in the former part and the latter part of each charging range, to receive an input of the first cell voltage time-series data and output the predicted cell voltage time-series data having a minimum error with the second cell voltage time-series data.

According to another aspect, the control unit may be configured to, for each of the first to N-th cells, determine a maximum difference between the second cell voltage time-series data and the predicted cell voltage time-series data as the error for each charging range; determine "(the error - the first average)/the first standard deviation" corresponding to a first standardized value of the error of each of the first to N-th cells for each charging range, and detect any cell in which the first standardized value is larger than a first threshold in at least one of the charging ranges as the latent defective cell. Here, the first average and the first standard deviation may be pre-determined values in the training process of the deep learning model.

Optionally, the control unit may be configured to, for each of first to p-th modules of the battery pack, determine a second average and a second standard deviation of the error of each of the plurality of cells included in the module; and determine "(the error - the second average)/the second standard deviation" corresponding to a second standardized value of the error of each of the first to N-th cells for each charging range, and detect, as the latent defective cell, any battery cell in which the first standardized value is larger than the first threshold and the second standardized value is larger than a second threshold in at least one of the charging ranges.

Optionally, the control unit may be configured to, for each of the first to N-th cells, monitor if a relative change behavior of the second cell voltage time-series data and the predicted cell voltage time-series data as the charging range shifts corresponds to a predefined change behavior pattern for each latent defect type, and finally determine the latent defect type of any cell for which the predefined change behavior pattern is found in a reference number of times or more.

Preferably, the predefined change behavior pattern may be that the second cell voltage time-series data increases faster than the predicted cell voltage time-series data in the charging range at an early stage and the predicted cell voltage time-series data increases faster than the second cell voltage time-series data in the charging range at a later stage, and the latent defect type may be a lithium plating at a negative electrode.

The apparatus according to the present disclosure may further include a recording storage medium configured to store data, a predefined parameter, a program or a combination thereof; and a display. Additionally, the control unit may be configured to record identification information associated with the detected latent defective cell in the recording storage medium, or output a message notifying that the latent defective cell is detected in the battery pack through the display, or transmit the identification information of the latent defective cell to an external device via communication.

The technical problem according to the present disclosure may be solved by a battery management system including the above-described apparatus for detecting a latent defective cell in a battery pack.

To solve the above-described technical problem, a method for detecting a latent defective cell in a battery pack according to another aspect of the present disclosure includes, during charging of the battery pack according to a charging profile having a plurality of charging ranges, for each of first to N-th cells in each charging range, (a) acquiring first cell voltage time-series data in a former part of the charging range; (b) determining predicted cell voltage time-series data in a latter part of the charging range by applying a deep learning model to the first cell voltage time-series data; (c) acquiring second cell voltage time-series data in the latter part; (d) determining an error between the second cell voltage time-series data and the predicted cell voltage time-series data; and (e) detecting any cell having a larger error than other cells in at least one of the charging ranges as the latent defective cell.

Advantageous Effects

According to the present disclosure, it is possible to easily detect a latent defective cell by dividing the charging profile of the battery pack into the plurality of charging ranges, and statistically comparing and analyzing the behaviors of the actually measured voltage and the predicted voltage for each charging range. Accordingly, it is possible to prevent human accidents by detecting latent defects directly related to fire or explosion accidents, especially, serious latent defects such as lithium plating at the negative electrode in the early stage and providing warnings to users. Additionally, in addition to the lithium plating at the negative electrode, the present disclosure may detect voltage change behaviors caused by swelling or micro short circuits, thereby effectively dealing with other latent defects.

DESCRIPTION OF DRAWINGS

The accompanying drawings illustrate an exemplary embodiment of the present disclosure, and together with the following detailed description, serve to provide a further understanding of the technical aspect of the present disclosure, and thus the present disclosure should not be construed as being limited to the drawings.

FIG. 1 is a schematic block diagram of an apparatus for detecting a latent defective cell in a battery pack according to an embodiment of the present disclosure.
FIG. 2 is a graph showing an example of a charging profile according to an embodiment of the present disclosure.
FIG. 3 is a graph showing voltage change behaviors of cells during the charging of a battery pack according to the charging profile shown in FIG. 2.
FIG. 4 is a graph showing an example of a former part and a latter part of a charging range set in a charging profile according to an embodiment of the present disclosure.

FIG. 5 is a graph showing an example of first and second cell voltage time-series data measured in each charging range during the charging of first to m-th training cells according to a charging profile of an embodiment of the present disclosure.

FIG. 6 is a graph showing changes in second cell voltage time-series data $V_{k,i}(j)$ measured in the latter part of a charging range ② of a charging profile for a specific cell in which a latent defect is detected, predicted cell voltage time-series data $V^*_{k,i}(j)$ predicted by a deep learning model and "$V_{k,i}(j)-V^*_{k,i}(j)$" corresponding to a difference between them.

FIG. 7 is a graph showing changes in second cell voltage time-series data $V_{k,i}(j)$ measured in the latter part of charging ranges ① to ⑤ of a charging profile for a specific cell having lithium plating at a negative electrode, predicted cell voltage time-series data $V^*_{k,i}(j)$ predicted by a deep learning model and "$V_{k,i}(j)-V^*_{k,i}(j)$" corresponding to a difference between them.

FIGS. 8 to 10 are flowcharts showing the sequence of a method for detecting a latent defective cell in a battery pack according to an embodiment of the present disclosure.

## BEST MODE

Hereinafter, an exemplary embodiment of the present disclosure will be described with reference to the accompanying drawings. Prior to the description, it should be understood that the terms or words used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the embodiments described herein and the illustrations in the drawings are just an exemplary embodiment of the present disclosure, but not intended to fully describe the technical aspect of the present disclosure.

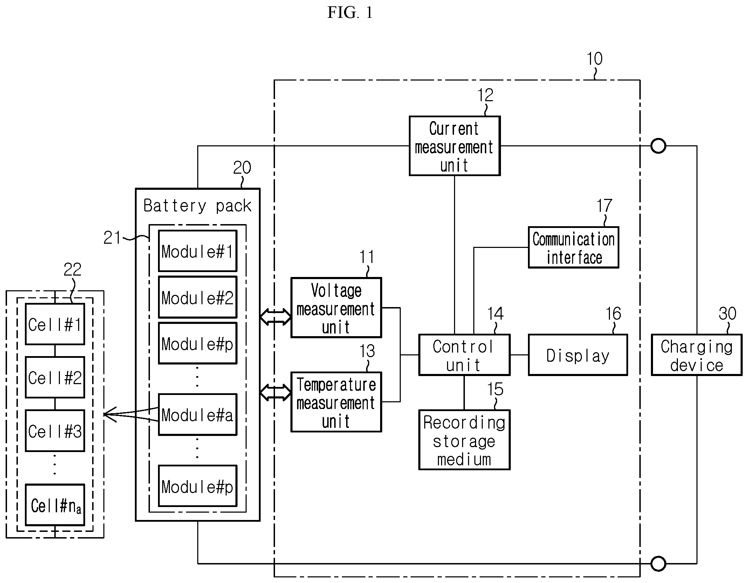

FIG. 1 is a schematic block diagram of an apparatus for detecting a latent defective cell in a battery pack according to an embodiment of the present disclosure.

Referring to FIG. 1, the apparatus 10 according to an embodiment of the present disclosure is designed to detect a latent defective cell in a battery pack 20 while the battery pack 20 is being charged by a charging device 30 according to a charging profile having a plurality of charging ranges.

The latent defective cell refers to a cell showing an abnormal voltage change behavior that is different from that of a normal cell. For example, in the case of a lithium polymer cell, when lithium plating at the negative electrode or a micro short circuit or swelling in the cell occurs, voltage change behaviors during cell charging are different from that of a normal cell.

The battery pack 20 includes first to p-th modules 21. The first to p-th modules 21 may be connected in series and/or in parallel. An a-th module includes first to $n_a$-th cells 22. The $n_a$ is the total number of cells included in the a-th module. The first to $n_a$-th cells 22 may be connected in series and/or in parallel. The number of cells in each module may be equal or different. The total number of cells included in the battery pack 20 is $\sum_{a=1}^{p} n_a$. Hereinafter, the total number of cells included in the battery pack 20 may be defined as N, and all the cells in the battery pack 20 may be referred to as first to N-th cells.

In an embodiment, the first to N-th cells may be pouch-type lithium polymer cells. However, it is obvious that the present disclosure is not limited to the type of cell or packaging material. Accordingly, the present disclosure may be applied to any other type of secondary battery cell such as a lithium-sulfur battery, a sodium battery or the like. Additionally, the present disclosure may be applied to a cell having a structure of a cylindrical cell and a prismatic cell or the like.

The charging device 30 is a device that applies the charging current to the battery pack 20 according to the charging profile having the plurality of charging ranges. When the battery pack 20 is mounted in an electric vehicle, the charging device 30 may be a charging station. In another example, when the battery pack 20 is mounted in an energy storage system, the charging device 30 may be a Power Converting System (PCS) installed between the energy storage system and an electrical grid. The PCS is a system that controls the charge/discharge of the energy storage system.

In the present disclosure, the charging profile is a protocol defining changes in the magnitude of the charge current supplied to the battery pack 20 over time.

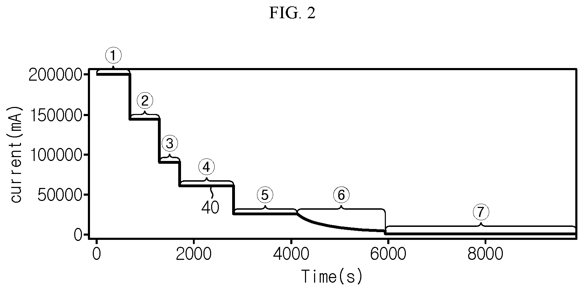

FIG. 2 is a graph showing an example of the charging profile 40 according to an embodiment of the present disclosure.

Referring to FIG. 2, the charging profile 40 has the plurality of charging ranges ① to ⑦. Each charging range differs in the magnitude and duration of the charging current. The duration is a period of time during which each charging range is maintained.

In an embodiment, the charging profile 40 is a step charging profile. In the step charging profile, the magnitude of the charging current decreases stepwise until the voltage of cells included in the battery pack 20 reaches the cut-off voltage, and subsequently, the magnitude of the charging current is adjusted according to a constant-voltage charging mode.

In FIG. 2, the charging ranges ① to ⑤ are ranges in which the magnitude of the charging current decreases stepwise until the cut-off voltage, the charging range ⑥ is a range in which the constant-voltage charging mode is applied, and the charging range ⑦ is a range in which the charging current of small magnitude substantially close to 0 is applied until the battery cell is fully charged. In the charging profile 40, the substantial charging range is the charging ranges ① to ⑥.

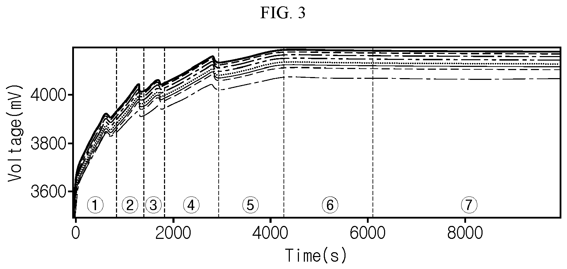

FIG. 3 is a graph showing the voltage change behaviors of cells during the charging of the battery pack 20 according to the charging profile 40 shown in FIG. 2.

The cells are lithium polymer cells that operate at 3.2V to 4.2V. The total number of cells is 100, and since the degree of degradation of the cells is not the same, the voltage change behaviors of the cells are different.

Meanwhile, the present disclosure is not limited to a specific change pattern of the charging profile 40. Accordingly, the charging profile 40 of FIG. 2 is just an example. It should be understood that when a certain charging profile has a plurality of charging ranges, the corresponding profile corresponds to the charging profile according to the present disclosure.

Referring back to FIG. 1, the apparatus 10 according to the present disclosure includes a voltage measurement unit 11, a current measurement unit 12, a temperature measurement unit 13 and a control unit 14.

The voltage measurement unit 11 measures the voltage of the first to N-th cells included in the battery pack 20 at a predetermined time interval during the charging of the battery pack 20 according to the charging profile 40 having the plurality of charging ranges, and outputs the cell voltage measurement value to the control unit 14.

The voltage measurement unit 11 may include a voltage measurement circuit known in the corresponding technical field, and since the voltage measurement circuit is well known, its description is omitted.

The current measurement unit 12 measures the magnitude of the charging current at a predetermined time interval during the charging of the battery pack 20 according to the charging profile 40 having the plurality of charging ranges, and outputs the current measurement value to the control unit 14.

The current measurement unit 12 may be a hall effect sensor or a sense resistor that outputs the voltage value corresponding to the magnitude of the electric current. The voltage value may be converted to the current value according to the ohm's law. When the cells in the first to p-th modules 21 are connected in series and the first to p-th modules 21 are also connected in series, the current measurement unit 12 may be installed on a line in which the charging current flows. In this example, the current measurement value measured by the current measurement unit 12 corresponds to the cell current value of all the cells included in the battery pack 20. It is obvious to those skilled in the art that when there are cells or modules connected in parallel, the current measurement unit 12 may be additionally installed at an optimal point of the line in which the charging current flows to measure the cell current value.

The temperature measurement unit 13 measures the temperature of the first to N-th cells at a predetermined time interval during the charging of the battery pack 20 according to the charging profile 40 having the plurality of charging ranges and outputs the cell temperature measurement value to the control unit 14.

The temperature measurement unit 13 may be a thermocouple or a temperature measurement device that outputs the voltage value corresponding to the temperature. The voltage value may be converted to the temperature value using a voltage-temperature conversion look-up table (function).

The temperature measurement unit 13 may be attached to each of the first to p-th modules 21. In this case, the temperature of each module may be regarded as the temperature of the cells included in the module. The present disclosure does not limit to install the temperature measurement unit 13 for each cell.

The control unit 14 acquires first and second cell voltage time-series data for each cell by periodically receiving the input of the cell voltage value of the first to N-th cells from the voltage measurement unit 11 in each charging range during the charging of the battery pack 20 according to the charging profile 40. Here, the cell voltage time-series data is a set of cell voltage data continuously measured at a plurality of time points.

In an embodiment, the first cell voltage time-series data is a set of cell voltage data measured in the former part of each charging range. Additionally, the second cell voltage time-series data is a set of cell voltage data measured in the latter part of each charging range.

The boundary of the former part and the latter part of the charging range may be arbitrarily set. In an example, when the duration of the i-th charging range is $T_i$, the former part of the charging range is from the starting time of the charging range to time $0.3T_i$, and the latter part of the charging range may from time $0.3T_i$ to time $T_i$. In this example, the duration of the former part is $0.3T_i$, and the duration of the latter part is $0.7T_i$.

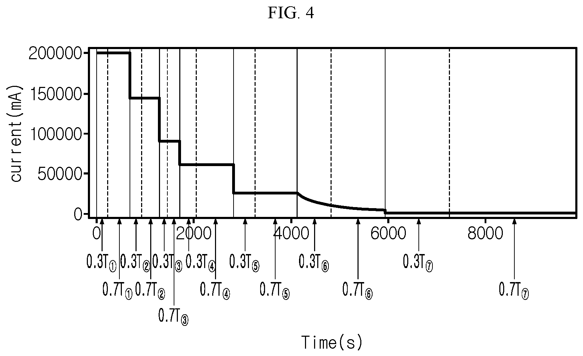

FIG. 4 is a graph showing an example of the former part and the latter part of the charging range set in the charging profile 40 according to an embodiment of the present disclosure.

In FIG. 4, the vertical solid line indicates the boundary between the charging ranges, and the dashed line indicates the boundary of the former part and the latter part of the charging range. The duration of the former part and the latter part of the charging range ① is $0.3T_①$ and $0.7T_①$, respectively. Additionally, the duration of the former part and the latter part of the charging range ② is $0.3T_②$ and $0.7T_②$, respectively. Additionally, the duration of the former part and the latter part of the charging range ③ is $0.3T_{③}$ and $0.7T_{③}$, respectively. Additionally, the duration of the former part and the latter part of the charging range ④ is $0.3T_{④}$ and $0.7T_{④}$, respectively. Additionally, the duration of the former part and the latter part of the charging range ⑤ is $0.3T_{⑤}$ and $0.7T_{⑤}$, respectively. Additionally, the duration of the former part and the latter part of the charging range ⑥ is $0.3T_{⑥}$ and $0.7T_{⑥}$, respectively. Additionally, the duration of the former part and the latter part of the charging range ⑦ is $0.3T_{⑦}$ and $0.7T_{⑦}$, respectively.

The duration of the charging range may be different for each charging range. Additionally, the duration of the former part and the latter part of the charging range may be equal all over the entire charging range or different for each charging range. That is, the boundary of the former part and the latter part of the charging range may be set to an arbitrary time in the duration of the charging range.

Apart from acquiring the first and second cell voltage time-series data of the first to N-th cells through the voltage measurement unit 11 in each charging range, the control unit 14 may determine predicted cell voltage time-series data in the latter part of the charging range by applying a deep learning model to the first cell voltage time-series data in each charging range.

The deep learning model is a pre-trained model to receive the input of the first cell voltage time-series data measured in the former part of each charging range for each training cell during the charging of first to m-th training cells having the same specification as the cell in the battery pack 20 according to the above-described charging profile 40 and output the predicted cell voltage time-series data having a minimum error with the second cell voltage time-series data measured in the latter part of the corresponding charging range.

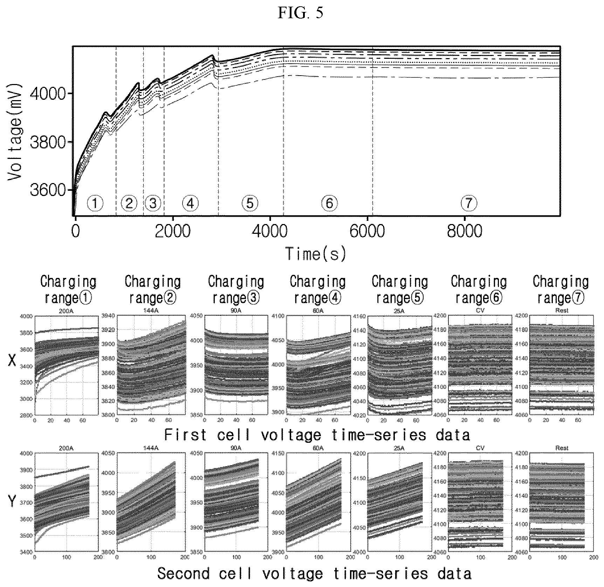

FIG. 5 is a graph showing an example of the first and second cell voltage time-series data measured in each charging range during the charging of the first to m-th training cells according to the charging profile according to an embodiment of the present disclosure.

The graph in the upper part of FIG. 5 shows exemplarily voltage curves of 100 training cells among m training cells in an overlapping manner, and the graph in the lower part of FIG. 5 shows exemplarily the first cell voltage time-series data and the second cell voltage time-series data measured in the charging ranges ① to ⑦.

Preferably, a few thousands to tens of thousands of training cells having different degrees of degradation may be used to improve the accuracy and reliability of the deep learning model during the training of the model.

Referring to FIG. 5, the deep learning model may be pre-trained to receive the input of the first cell voltage time-series data X measured in the training cells in the former part of the charging range ① and output the predicted cell voltage time-series data having the minimum error with the second cell voltage time-series data Y measured in the training cells in the latter part of the charging range ①. Additionally, the deep learning model may be pre-trained to receive the input of the first cell voltage time-series data X measured in the training cells in the former part of the charging range ② and output the predicted cell voltage time-series data having the minimum error with the second cell voltage time-series data Y measured in the training cells in the latter part of the charging range ②. Additionally, the deep learning model may be pre-trained to receive the input of the first cell voltage time-series data X measured in the training cells in the former part of the charging range ③ and output the predicted cell voltage time-series data having the minimum error with the second cell voltage time-series data Y measured in the training cells in the latter part of the charging range ③. Additionally, the deep learning model may be pre-trained to receive the input of the first cell voltage time-series data X measured in the training cells in the former part of the charging range ④ and output the predicted cell voltage time-series data having the minimum error with the second cell voltage time-series data Y measured in the training cells in the latter part of the charging range ④. Additionally, the deep learning model may be pre-trained to receive the input of the first cell voltage time-series data X measured in the training cells in the former part of the charging range ⑤ and output the predicted cell voltage time-series data having the minimum error with the second cell voltage time-series data Y measured in the training cells in the latter part of the charging range ⑤. Additionally, the deep learning model may be pre-trained to receive the input of the first cell voltage time-series data X measured in the training cells in the former part of the charging range ⑥ and output the predicted cell voltage time-series data having the minimum error with the second cell voltage time-series data Y measured in the training cells in the latter part of the charging range ⑥. Additionally, the deep learning model may be pre-trained to receive the input of the first cell voltage time-series data X measured in the training cells in the former part of the charging range ⑦ and output the predicted cell voltage time-series data having the minimum error with the second cell voltage time-series data Y measured in the training cells in the latter part of the charging range ⑦.

More preferably, in addition to the first cell voltage time-series data measured in the former part of the charging range, the data used to train the deep learning model may further include time-series data of the cell current and the cell temperature measured in the former part of the charging range. In this case, the deep learning model may be trained to receive the input of the first cell voltage time-series data, the cell current time-series data and the cell temperature time-series data measured in the former part of the charging range and output the predicted cell voltage time-series data having the minimum error with the second cell voltage time-series data measured in the latter part of the charging range.

Preferably, the deep learning model may include any model based on an artificial neural network suitable to predict the time-series behavior of the cell voltage. For example, the artificial neural network may include Recurrent Neural Network (RNN), Convolution Neural Network (CNN) or the like. However, the present disclosure is not limited to the type of artificial neural network.

After the control unit 14 acquires the second cell voltage time-series data and the predicted cell voltage time-series data in the latter part of each charging range for each of the first to N-th cells in the battery pack 20, the control unit 14 may determine an error between the second cell voltage time-series data (the measured value) and the predicted cell voltage time-series data (the predicted value).

Additionally, the control unit 14 may monitor the error between the second cell voltage time-series data and the predicted cell voltage time-series data determined in each charging range for each of the first to N-th cells, and detect a cell having a larger error in at least one charging range as a latent defective cell.

Specifically, the control unit 14 may calculate the error $E_{k,1}$ between the second cell voltage time-series data $V_{k,1}$ (j) and the predicted cell voltage time-series data $V_{k,1}^{*}$(j) of the first cell for each charging range using the following Equation 1.

<Equation 1>

$$E_{k,i} = \max(|V_{k,i}(j) - V_{k,i}^{*}(j)|), \ 1 \leq j \leq Num_{measure}$$

k: Index of charging range
$E_{k,i}$: Error of k-th charging range for i-th battery cell
$V_{k,i}(j)$: j-th second cell voltage of i-th battery cell measured in the latter part of the k-th charging range
$V_{k,i}^{*}(j)$: j-th predicted cell voltage of i-th battery cell predicted by the deep learning model in the latter part of k-th charging range
$Num_{measure}$: Total number of times cell voltage is measured in the latter part of k-th charging range or the total number of times cell voltage is predicted using the deep learning model in the latter part of k-th charging range
max(): Function that returns the maximum value among the plurality of input values

Additionally, the control unit 14 may calculate the error $E_{k,2}$, $E_{k,3}$,..., $E_{k,n}$ between the second cell voltage time-series data and the predicted cell voltage time-series data of the second to N-th cells for each charging range.

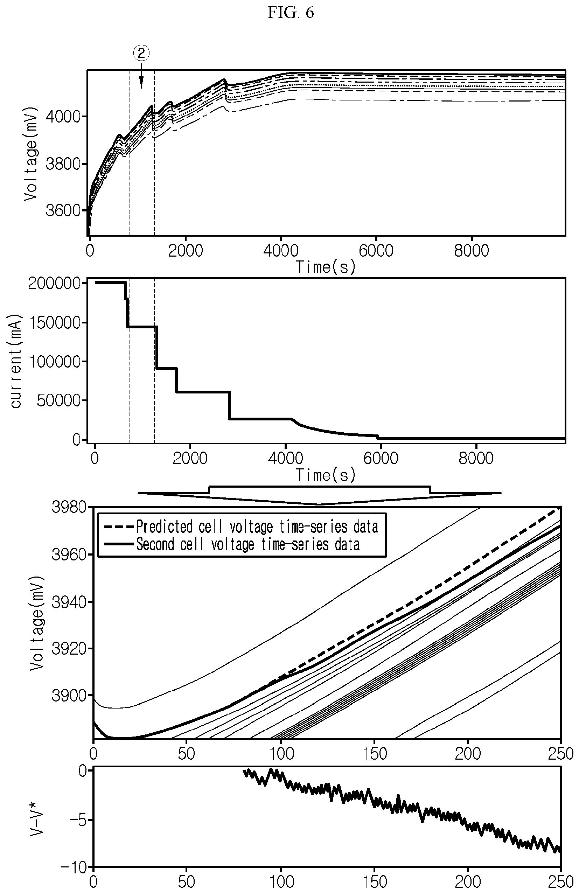

FIG. 6 is a graph showing changes in the second cell voltage time-series data $V_{k,i}(j)$ measured in the latter part of the charging range ② of the charging profile 40 for a specific cell in which a latent defect is detected, the predicted cell voltage time-series data $V_{k,i}^{*}(j)$ predicted by the deep learning model and "$V_{k,i}(j)-V_{k,i}^{*}(j)$" corresponding to a difference between them.

The black solid line indicates $V_{k,i}(j)$, and the black dashed line indicates $V_{k,i}^{*}(j)$. Referring to FIG. 6, it can be seen that the latent defective cell has an increase in "$V_{k,i}(j)-V_{k,i}^{*}(j)$" to a significant level in the specific charging range. Accordingly, the error $E_{k,i}$ may be used as the parameter for the detection of the latent defective cell. For reference, the second cell voltage time-series data and the predicted cell voltage time-series data of cells having no latent defect are indicated by the grey lines and they match and cannot be distinguished.

Additionally, the control unit 14 may determine a first average $Avr_k$ and a first standard deviation $\sigma_k$ of the error $E_{k,i}$ of the first to N-th cells for each charging range using the following Equation 2.

<Equation 2>

$$Avr_k = mean(E_{k,i}), \ 1 \leq i \leq N$$

$$\sigma_k = std(E_{k,i}), \ 1 \leq i \leq N$$

i: Index of cell
N: Number of cells in battery pack
k: Index of charging range
$E_{k,i}$: Error of k-th charging range for i-th battery cell
mean( ): Function that returns the average value of the plurality of input values
std( ): Function that returns the standard deviation of the plurality of input values

Additionally, the control unit 14 may determine a first standardized value $Std\_Value_{k,i}$ of the error $E_{k,i}$ of each of the first to N-th cells using the following Equation 3 for each charging range. When the number of charging ranges is $Num_{charge}$, the number of first standardized values $Std\_Value_{k,i}$ for each cell is $Num_{charge}$.

<Equation 3>

$$\text{Std\_Value}_{k,i} = (E_{k,i} - \text{Avr}_k)/\sigma_k, \ 1 \leq k \leq \text{Num}_{\text{charge}}$$

i: Index of cell
k: Index of charging range
$\text{Num}_{\text{charge}}$: Number of charging ranges
$\text{Avr}_k$: First average of k-th charging range
$\sigma_k$: First standard deviation of k-th charging range

Additionally, the control unit 14 may detect, as the latent defective cell, any of the first to N-th cells of the battery pack 20 in which the first standardized value $\text{Std\_Value}_{k,i}$ is larger than a preset first threshold in at least one charging range.

The first standardized value $\text{Std\_Value}_{k,i}$ is a factor indicating how much the error $E_{k,i}$ of the i-th cell determined in the k-th charging range is far from the average error value $\text{Avr}_k$ on the basis of the standard deviation $\sigma_k$ of error.

For example, when $\text{Std\_Value}_{k,i}$ is 2, a difference between $E_{k,i}$ and the average error is double the standard deviation of error. Accordingly, any cell in which the first standardized value $\text{Std\_Value}_{k,i}$ is larger than other cells in the k-th charging range may be regarded as a cell in which a defect is likely to occur due to the relatively large error between the measured cell voltage and the predicted cell voltage. It is because a difference between voltage change behavior (change behavior of the second cell voltage) of the latent defective cell and voltage change behavior (change behavior of the predicted cell voltage) of normal cells is large.

Preferably, the first threshold may be set to 3 or more, more preferably 4 or more, and much more preferably 4.5 or more.

Meanwhile, in Equation 3, the first average $\text{Avr}_k$ and the first standard deviation $\sigma_k$ of each charging range may be pre-determined in the training process of the deep learning model. That is, after the training of the deep learning model is completed, the first cell voltage time-series data, the second cell voltage time-series data and the predicted cell voltage time-series data may be collected during the charging of the first to m-th training cells according to the charging profile 40 having the plurality of charging ranges, and the error $E_{k,i}$ of each charging range may be determined for each training cell. Additionally, the average and the standard deviation of the error $E_{k,i}$ calculated using Equation 2 for each charging range may be preset as the first average $\text{Avr}_k$ and the first standard deviation $\sigma_k$.

Optionally, the control unit 14 may determine a second average $\text{Avr}_{k,a}$ and a second standard deviation $\sigma_{k,a}$ of the error $E_{k,i}$ for each module using the following Equation 4. Preferably, the second average $\text{Avr}_{k,a}$ and the second standard deviation $\sigma_{k,a}$ are determined for each charging range.

<Equation 4>

$$\text{Avr}_{k,a} = \text{mean}(E_{k,i@a}), \ 1 \leq i \leq n_a, \ 1 \leq k \leq \text{Num}_{\text{charge}}$$

$$\sigma_{k,a} = \text{std}(E_{k,i}), \ 1 \leq i \leq n_a, \ 1 \leq k \leq \text{Num}_{\text{charge}}$$

a: Index of module
i: Index of cell
$n_a$: Total number of cells included in a-th module
k: Index of charging range
$\text{Num}_{\text{charge}}$: Total number of charging ranges
$E_{k,i@a}$: Error in k-th charging range for i-th cell in a-th module
mean( ): Function that returns the average value of the plurality of input values
std( ): Function that returns the standard deviation of the plurality of input values

Additionally, the control unit 14 may determine a second standardized value $\text{Std\_Value}^*_{k,i}$ in the module for the error $E_{k,i}$ of each of the first to N-th cells using the following Equation 5 for each charging range. The number of second standardized values $\text{Std\_Value}^*_{k,i}$ in the module for each cell is $\text{Num}_{\text{charge}}$.

<Equation 5>

$$\text{Std\_Value}^{*}_{k,i} = (E_{k,i} - \text{Avr}_{k,a})/\sigma_{k,a}, \ 1 \leq i \leq N, \ 1 \leq a \leq p, \ 1 \leq k \leq \text{Num}_{\text{charge}}$$

i: Index of battery cell, N is Total number of cells
a: Index of module, p is Total number of modules
k: Index of charging range, $\text{Num}_{\text{charge}}$ is the total number of charging ranges
$\text{Avr}_{k,a}$: Second average defined for the module in which the cell is included
$\sigma_{k,a}$: Second standard deviation defined for the module in which the cell is included

Additionally, the control unit 14 may be configured to detect, as the latent defective cell, any cell in which the first standardized value $\text{Std\_Value}_{k,i}$ is larger than the first threshold and the second standardized value $\text{Std\_Value}^{*}_{k,i}$ in the module is larger than a second threshold in at least one charging range.

The second standardized value $\text{Std\_Value}^{*}_{k,i}$ is a factor indicating how much the error $E_{k,i}$ of the cell determined in the k-th charging range is far from the average value $\text{Avr}_{k,a}$ of error in the module on the basis of the standard deviation $\sigma_{k,a}$ of error in the module.

For example, when $\text{Std\_Value}^{*}_{k,i}$ is 2, a difference between $E_{k,i}$ and the average error in the module is double the standard deviation of error in the module. Accordingly, any cell in which the second standardized value $\text{Std\_Value}^{*}_{k,i}$ is larger than other cells in one module may be regarded as a cell in which a defect is likely to occur since the error between the measured cell voltage and the predicted cell voltage is larger than other cell in the module.

Preferably, the second threshold may be smaller than the first threshold. In an example, the second threshold may be preferably set to 3.0 or less, and more preferably 2.5 or less.

Optionally, the control unit 14 may be further configured to perform the logic that detects the latent defect type of the battery cell.

Specifically, the control unit 14 may monitor if a relative change behavior of the second cell voltage time-series data of the first to N-th cells measured in the latter part of each charging range and the predicted cell voltage time-series data predicted in the latter part of each charging range as the charging range shifts shows a predefined change behavior pattern for each latent defect type. Additionally, when the predefined change behavior is detected in the same cell in a reference number of times or more during a plurality of charging cycles, the control unit 14 may identify the corresponding cell as the latent defective cell and determine the latent defect type.

In an example, when lithium plating at the negative electrode occurs in the lithium polymer cell, the second cell voltage time-series data increases faster than the predicted cell voltage time-series data in the charging range at the early stage of charging. It is because the potential of the negative electrode increases at the early stage of charging when lithium plating at the negative electrode occurs. Since the cell voltage corresponds to a difference between the positive electrode potential and the negative electrode potential, when the negative electrode potential increases, a slope of change in cell voltage increases. As a result, the second cell voltage increases faster than the predicted cell voltage at the early stage of charging. Since the predicted cell voltage is a predicted voltage by the deep learning model, and thus shows voltage change behaviors close to normal cells at the early stage of charging, the increase in the predicted cell voltage is not sharp.

Additionally, as opposed to the foregoing description, the predicted cell voltage time-series data increases faster than the second cell voltage time-series data in the charging range at the later stage of charging. The potential of the negative electrode decreases slowly during charging, and when lithium plating at the negative electrode occurs, the amount of lithium participating in the electrochemical reaction decreases, and the potential decline of the negative electrode is lessened. When the potential decline of the negative electrode is lessened, the increase in cell voltage is lessened as much. As a result, in the charging range at the later stage of charging, rather, the predicted cell voltage increases faster than the second cell voltage. Since the predicted cell voltage is a predicted voltage by the deep learning model and shows voltage change behaviors close to normal cells at the later stage of charging, the potential decline of the negative electrode is not lessened.

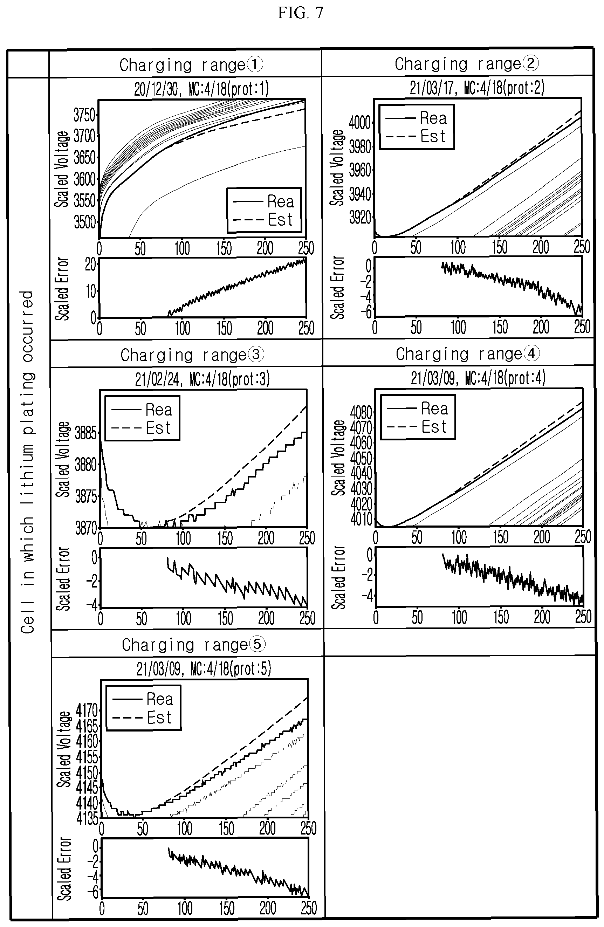

FIG. 7 is a graph showing changes in the second cell voltage time-series data $V_{k,i}(j)$ measured in the latter part of the charging ranges ① to ⑤\ of the charging profile 40 for a specific cell in which lithium plating at the negative electrode occurred, the predicted cell voltage time-series data $V^{*}_{k,i}(j)$ predicted by the deep learning model and "$V_{k,i}(j)-V^{*}_{k,i}(j)$" corresponding to a difference between them. In each graph, the horizontal axis is time (sec), and the vertical axis is voltage (milli-volt).

The black solid line indicates $V_{k,i}(j)$, and the black dashed line indicates $V^{*}_{k,i}(j)$. As can be seen from FIG. 7, in the cell in which lithium plating occurred, the second cell voltage time-series data increases faster than the predicted cell voltage time-series data in **the charging** range ① at the early stage of charging. Additionally, in the charging ranges ③, ④ and ⑤, on the contrary, the predicted cell voltage time-series data increases faster than the second cell voltage time-series data. The second cell voltage time-series data and the predicted cell voltage time-series data of cells having no latent defect are indicated by the grey lines and they match and cannot be distinguished.

In an embodiment, when the control unit 14 detects any of the first to N-th cells to show behaviors that the second cell voltage time-series data increases faster than the predicted cell voltage time-series data in the charging range at the early stage of charging and the predicted cell voltage time-series data increases faster than the second cell voltage time-series data in the charging range at the later stage of charging, the control unit 14 may identify the latent defect of the corresponding cell as lithium plating at the negative electrode.

Optionally, each time the control unit 14 detects any of the first to N-th cells to show behaviors that the second cell voltage time-series data increases faster than the predicted cell voltage time-series data in the charging range at the early stage during the charging of the battery pack 20 according to the charging profile 40 including the plurality of charging ranges, and the predicted cell voltage time-series data increases faster than the second cell voltage time-series data in the charging range at the later stage of charging, the control unit 14 may increase the latent defect count of the corresponding cell by 1.

Additionally, when the latent defect count is equal to or larger than the reference number of times, the control unit 14 may finally determine the latent defect of the corresponding cell as lithium plating at the negative electrode.

Referring back to FIG. 1, the apparatus 10 according to the present disclosure may further include a recording storage medium 15 to store data, predefined parameters, programs or a combination thereof, and a display 16.

When the latent defective cell is detected according to the above-described embodiment, the control unit 14 may record identification information of the latent defective cell and/or information associated with the latent defect type in the recording storage medium 15 together with the time stamp.

The identification information of the latent defective cell includes the model code of the battery pack 20, the module code to which the latent defective cell belongs, the production lot number of the latent defective cell or a combination thereof. The information associated with the latent defect type may include diagnosis code indicating lithium plating at the negative electrode.

Additionally, when the latent defective cell is detected according to the above-described embodiment, the control unit 14 may be configured to output a message notifying that the latent defective cell is detected in the battery pack 20 through the display 16.

When the battery pack 20 is mounted in an electric vehicle, the display 16 may be a dashboard or an integrated automotive control display of the electric vehicle. In another example, when the battery pack 20 is mounted in an energy storage system, the display 16 may be a display included in an integrated control computer of the energy storage system. However, the present disclosure is not limited to the type of the display.

Meanwhile, the apparatus 10 according to the present disclosure may further include a communication interface 17. In this case, the control unit 14 may transmit the identification information associated with the latent defective cell and/or the information associated with the latent defect type to an external device through the communication interface 17.

The communication interface 17 supports wired or wireless communication. The communication interface 17 may support data transmission/reception by Controller Area Network (CAN), Daisy Chain, RS-232 or the like. Additionally, the communication interface 17 may support data transmission/reception via near-field ratio communication, for example, Wi-Fi, Bluetooth, Zigbee or the like. Additionally, the communication interface 17 may support wide area data transmission/reception via wired/wireless Internet, base station communication or satellite communication.

The external device may be the charging device 30. In another example, the external device may be a cloud server that collects status information of the battery pack 20. In still another example, the external device may be a diagnosis device that investigates the performance of the battery pack 20.

In the present disclosure, the control unit 14 may selectively include a processor, an application-specific integrated circuit (ASIC), a chipset, a logic circuit, a register, a communication modem, a data processing device or the like, well known in the corresponding technical field, to execute various control logics.

The recording storage medium 15 is not limited to a particular type, and may include any recording medium capable of recording and erasing information. In an example, the recording storage medium 15 may be hard disk, RAM, ROM, EEPROM, register or flash memory. The recording storage medium 15 may store and/or update and/or erase and/or transmit programs including the control logics executed by the control unit 14 and/or data generated when the control logics are executed and predefined lookup tables, functions, parameters, chemical/physical/electrical constants or the like.

At least one of the control logics of the control unit 14 may be combined together, and the combined control logics may be written in computer-readable code and recorded in the recording storage medium 15. The code may be stored and executed in distributed computers connected via a network. Additionally, the functional programs, code and code segments for implementing the combined control logics can be easily inferred by programmers in the technical field pertaining to the present disclosure.

The apparatus 10 according to the present disclosure may be included in a battery management system or a battery diagnosis system. The battery management system is a system that controls the entire operation of the battery pack 20. The battery management system may be an integrated control system included in a load device in which the battery pack 20 is mounted, for example, an electric vehicle and an energy storage system. In addition to the battery management system or the battery diagnosis system, the apparatus 10 according to the present disclosure may be included as part of any other device or system, if necessary.

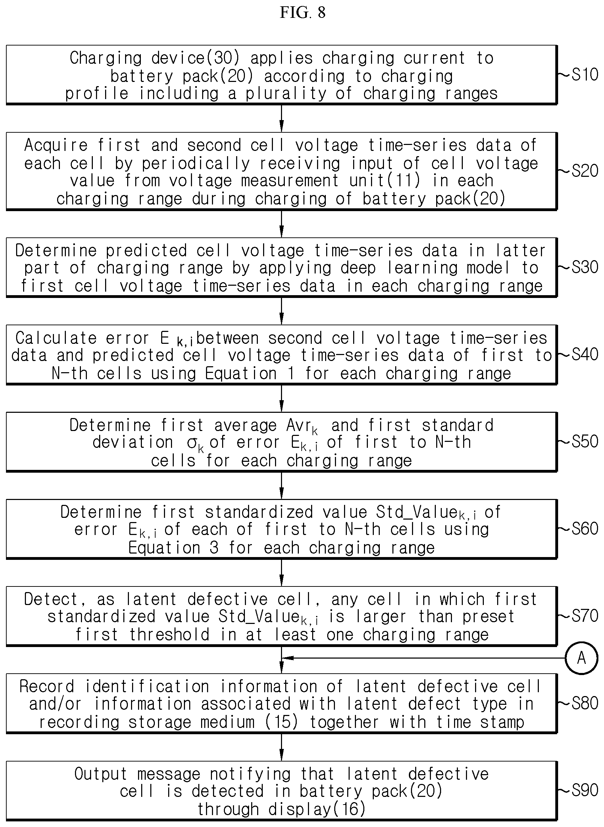

Hereinafter, a method for detecting a latent defective cell in a battery pack according to an embodiment of the present disclosure will be described with reference to FIGS. 8 to 10.

Referring to FIG. 8, first, in step S10, the charging device 30 applies the charging current to the battery pack 20 according to the charging profile 40 including the plurality of charging ranges. The charging device 30 may be the charging station of the electric vehicle or the PCS of the energy storage system.

The application of the charging current may start in response to a request from the control unit 14. That is, the control unit 14 may recognize the connection of a charging cable to the high potential line and low potential line of the battery pack 20, and request the charging device 30 to start to charge. Alternatively, when the charging device 30 is connected to the battery pack 20, the application of the charging current may automatically start.

Subsequently, in step S20, the control unit 14 acquires the first and second cell voltage time-series data by periodically receiving the input of the cell voltage value of the first to N-th cells in the battery pack 20 from the voltage measurement unit 11 in each charging range during the charging of the battery pack 20 according to the charging profile 40.

Subsequently, in step S30, apart from acquiring the first and second cell voltage time-series data through the voltage measurement unit 11 in each charging range, the control unit 14 determines the predicted cell voltage time-series data in the latter part of the corresponding charging range by applying the pre-trained deep learning model to the first cell voltage time-series data of the first to N-th cells in each charging range.

Subsequently, in step S40, the control unit 14 calculates the error $E_{k,i}$ between the second cell voltage time-series data and the predicted cell voltage time-series data of the first to N-th cells in each charging range using Equation 1. In step S40, when the number of charging ranges is $Num_{charge}$, the total number of errors $E_{k,i}$ is $Num_{charge}*N$.

Subsequently, in step S50, the control unit 14 determines the first average $Avr_k$ and the first standard deviation $\sigma_k$ of the error $E_{k,i}$ of the first to N-th cells for each charging range using Equation 2.

Subsequently, in step S60, the control unit 14 determines the first standardized value $Std\_Value_{k,i}$ of the error $E_{k,i}$ of each of the first to N-th cells using Equation 3 for each charging range. When the number of charging ranges is $Num_{charge}$, the total number of first standardized values $Std\_Value_{k,i}$ is $Num_{charge}*N$.

Subsequently, in step S70, the control unit 14 may detect, as the latent defective cell, any cell in which the first standardized value $Std\_Value_{k,i}$ is larger than the preset first threshold in at least one charging range.

After the step S70, step S80 or S90 may be selectively performed.

In the step S80, when the latent defective cell is detected, the control unit 14 may record the identification information of the latent defective cell and/or the information associated with the latent defect type in the recording storage medium 15 together with the time stamp. The identification information of the latent defective cell includes the model code of the battery pack 20, the module code to which the latent defective cell belongs, the production lot number of the latent defective cell or a combination thereof. The information associated with the latent defect type may include the diagnosis code indicating lithium plating at the negative electrode.

Additionally, in the step S90, when the latent defective cell is detected, the control unit 14 may output the message notifying that the latent defective cell is detected in the battery pack 20 through the display 16. In response to the output of the message, the user may stop using the battery pack 20 or replace the battery pack 20, or request a repair shop or an after service center to investigate the battery pack 20 in detail.

Meanwhile, the step S50 may be omitted. In this case, the first average $Avr_k$ and the first standard deviation $\sigma_k$ may be pre-determined in the training process of the deep learning model. That is, after the training of the deep learning model is completed, the error $E_{k,i}$ of each charging range may be determined for each training cell during the charging of the first to m-th training cells according to the charging profile 40. Additionally, the average and the standard deviation of the error $E_{k,i}$ may be calculated using Equation 2 for each charging range and each calculated value may be preset to the first average $Avr_k$ and the first standard deviation $\sigma_k$. The first average $Avr_k$ and the first standard deviation $\sigma_k$ set in the training process of the deep learning model may be pre-stored in the recording storage medium 15, and when the step S60 is performed, the pre-stored information may be referred by the control unit 14.

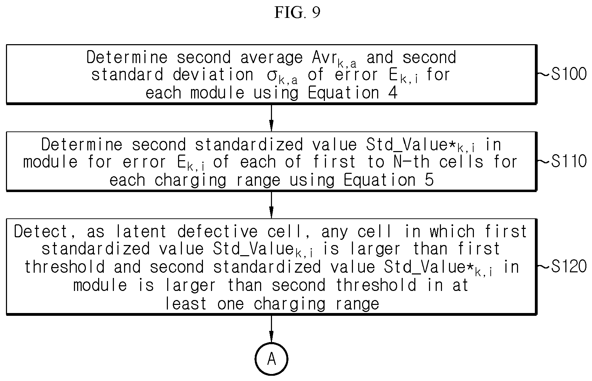

In a preferred embodiment, the steps after the step S60 may be modified as shown in FIG. 9.

That is, in step S100, the control unit 14 may determine the second average $Avr_{k,a}$ and the second standard deviation $\sigma_{k,a}$ of the error $E_{k,i}$ in each charging range for each module using Equation 4.

Subsequently, in step S110, the control unit 14 determines the second standardized value $Std\_Value^*_{k,i}$ in the module for the error $E_{k,i}$ of each of the first to N-th cells for each charging range using Equation 5. When the number of charging ranges is $Num_{charge}$, the number of second standardized values $Std\_Value^*_{k,i}$ in the module for each cell is $Num_{charge}$.

Subsequently, in step S120, the control unit 14 may detect, as the latent defective cell, any cell in which the first standardized value $Std\_Value_{k,i}$ is larger than the first threshold and the second standardized value $Std\_Value^*_{k,i}$ in the module is larger than the second threshold in at least one charging range.

Preferably, the second threshold may be smaller than the first threshold. In an example, the first threshold may be 3.0 or more, preferably 4.0 or more, and more preferably 4.5 or more. Additionally, the second threshold may be preferably set to 3.0 or less, and more preferably 2.5 or less.

After the step S120, in the same way as the above-described embodiment, the step S80 or S90 may be performed substantially equally.

That is, when the latent defective cell in the battery pack 20 is detected, the control unit 14 may record the identification information of the latent defective cell and/or the information associated with the latent defect type in the recording storage medium 15 together with the time stamp. The identification information of the latent defective cell includes the model code of the battery pack 20, the module code to which the latent defective cell belongs, the production lot number of the latent defective cell or a combination thereof. The information associated with the latent defect type may include the diagnosis code indicating lithium plating at the negative electrode.

Additionally, when the latent defective cell in the battery pack 20 is detected, the control unit 14 may output the message notifying that the latent defective cell is detected in the battery pack 20 through the display 16.

The method for detecting a latent defective cell in a battery pack according to the present disclosure may further include identifying the latent defect type of the battery cell.

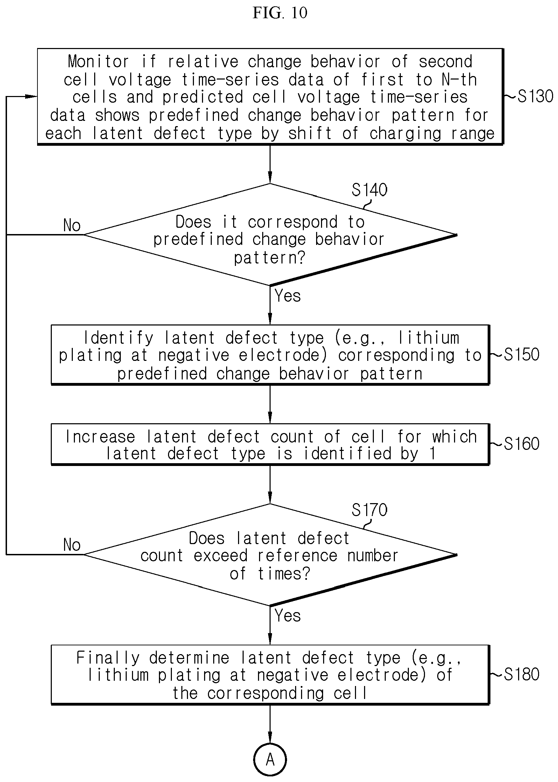

As shown in FIG. 10, in step S130, the control unit 14 may monitor if the relative change behavior of the second cell voltage time-series data of the first to N-th cells measured in the latter part of each charging range and the predicted cell voltage time-series data predicted in the latter part of each charging range as the charging range shifts shows the predefined change behavior pattern for each latent defect type.

In an embodiment, the control unit 14 may monitor if there is any of the first to N-th cells showing the behavior pattern in which the second cell voltage time-series data increases faster than the predicted cell voltage time-series data in the charging range at the early stage of charging, and the predicted cell voltage time-series data increases faster than the second cell voltage time-series data in the charging range at the later stage of charging.

Subsequently, in step S140, the control unit 14 determines if the relative change behavior of the second cell voltage time-series data and the predicted cell voltage time-series data corresponds to the predefined change behavior pattern for the latent defect type.

When the result of the step S140 is YES, step S150 is performed. On the contrary, when the result of the step S140 is NO, the process reverts to the step S130.

When the result of the step S140 is YES, the control unit 140 identifies the latent defect type corresponding to the predefined change behavior pattern in the step S150. In an embodiment, when the control unit 14 detects any of the first to N-th cells showing the behavior pattern in which the second cell voltage time-series data increases faster than the predicted cell voltage time-series data in the charging range at the early stage of charging, and the predicted cell voltage time-series data increases faster than the second cell voltage time-series data in the charging range at the later stage of charging, the control unit 14 may identify the latent defect of the corresponding cell as lithium plating at the negative electrode.

Subsequently, in step S160, the control unit 14 increases by 1 the latent defect count of the corresponding cell for which the latent defect type (for example, lithium plating at the negative electrode) is identified.

Subsequently, in step S170, the control unit 14 determines if the latent defect count exceeds the reference number of times.

When the determination of the step S170 is YES, step S180 is performed. On the contrary, when the determination of S170 is NO, the process reverts to the step S130.

When the determination of the step S170 is YES, the control unit 14 finally determines the latent defect type (for example, lithium plating at the negative electrode) for the cell in which the latent defect count is larger than the reference number of times in the step S180.

After the step S180 is performed, in the same way as the above-described embodiment, the step S80 or S90 may be performed.

That is, when the latent defect of the specific cell in the battery pack 20 is identified and the latent defect type is finally determined, the control unit 14 may record the identification information of the latent defective cell and the information associated with the latent defect type in the recording storage medium 15 together with the time stamp. The identification information of the latent defective cell includes the model code of the battery pack 20, the module code to which the latent defective cell belongs, the production lot number of the latent defective cell or a combination thereof. The information associated with the latent defect type may include the diagnosis code indicating lithium plating at the negative electrode.

Additionally, when the latent defective cell is identified in the battery pack 20 and the latent defect type is finally determined, the control unit 14 may output the message notifying that the latent defective cell is detected in the battery pack 20 through the display 16 together with the information associated with the latent defect type.

Meanwhile, the control unit 14 may transmit the identification information associated with the latent defective cell and/or information associated with the latent defect type to the external device through the communication interface 17.

The communication interface 17 may support wired communication or wireless communication.

The external device may be the charging device 30. In another example, the external device may be a cloud server that collects status information of the battery pack 20. **In** still another example, the external device may be a diagnosis device that investigates the performance of the battery pack 20.

**In** the present disclosure, in addition to lithium plating at the negative electrode, the latent defect type may include any other latent defect type, for example, cell swelling, a micro internal short circuit or the like. For each latent defect type, it is obvious to those skilled in the art that the relative change behavior pattern of the second cell voltage time-series data and the predicted cell voltage time-series data as the charging range shifts can be easily determined through the test.

According to the present disclosure, it is possible to easily detect a latent defective cell by dividing the charging profile of the battery pack 20 into the plurality of charging ranges, and statistically comparing and analyzing the behaviors of the actually measured voltage and the predicted voltage for each charging range. Accordingly, it is possible to prevent human accidents by detecting latent defects directly related to fire or explosion accidents, especially, serious latent defects such as lithium plating at the negative electrode in the early stage and providing warnings to users. Additionally, in addition to the lithium plating at the negative electrode, the present disclosure may detect voltage change behaviors caused by swelling, micro short circuits or the like, thereby effectively dealing with other latent defects.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the appended claims.

**Claims**

1. An apparatus (10) for detecting a latent defective cell in a battery pack (20), comprising:

   a voltage measurement unit (11), a current measurement unit (12) and a temperature measurement unit (13) to measure a voltage, a current and a temperature of first to N-th cells included in the battery pack (20) during charging of the battery pack (20), respectively, and
   a control unit (14) operably coupled to the voltage measurement unit (11), the current measurement unit (12) and the temperature measurement unit (13),
   wherein the control unit (14) is configured to, during the charging of the battery pack (20) according to a charging profile having a plurality of charging ranges, for each of the first to N-th cells in each charging range, acquire first cell voltage time-series data through the voltage measurement unit (11) in a former part of the charging range; determine predicted cell voltage time-series data in a latter part of the charging range by applying a deep learning model to the first cell voltage time-series data; acquire second cell voltage time-series data through the voltage measurement unit (11) in the latter part of the charging range, and determine an error between the second cell voltage time-series data and the predicted cell voltage time-series data, and
   wherein the control unit (14) is further configured to detect any cell having a larger error than other cells in at least one of the charging ranges as the latent defective cell.

2. The apparatus (10) for detecting a latent defective cell in a battery pack (20) according to claim 1, wherein the control unit (14) is configured to, for each of the first to N-th cells, determine a maximum difference between the second cell voltage time-series data and the predicted cell voltage time-series data as the error for each charging range; determine a first average and a first standard deviation of the error of the first to N-th cells for each charging range; determine "(the error - the first average)/the first standard deviation" corresponding to a first standardized value of the error of each of the first to N-th cells for each charging range, and detect any cell in which the first standardized value is larger than a first threshold in at least one of the charging ranges as the latent defective cell.

3. The apparatus (10) for detecting a latent defective cell in a battery pack (20) according to claim 1, wherein the deep learning model is pre-trained, using the first cell voltage time-series data and the second cell voltage time-series data of first to m-th training cells respectively measured in the former part and the latter part of each charging range, to receive an input of the first cell voltage time-series data and output the predicted cell voltage time-series data having a minimum error with the second cell voltage time-series data.

4. The apparatus (10) for detecting a latent defective cell in a battery pack (20) according to claim 3, wherein the control unit (14) is configured to, for each of the first to N-th cells, determine a maximum difference between the second cell voltage time-series data and the predicted cell voltage time-series data as the error for each charging range; determine "(the error - a first average)/a first standard deviation" corresponding to a first standardized value of the error of each of the first to N-th cells for each charging range, and detect any cell in which the first standardized value is larger than a first threshold in at least one of the charging ranges as the latent defective cell, and

wherein the first average and the first standard deviation are pre-determined values in the training process of the deep learning model.

5. The apparatus (10) for detecting a latent defective cell in a battery pack (20) according to claim 2 or 4, wherein the battery pack (20) includes first to p-th modules connected in series and/or in parallel, and

wherein the control unit (14) is configured to, for each of the first to p-th modules, determine a second average and a second standard deviation of the error of each of the plurality of cells included in the module; and determine "(the error - the second average)/the second standard deviation" corresponding to a second standardized value of the error of each of the first to N-th cells for each charging range, and detect, as the latent defective cell, any battery cell in which the first standardized value is larger than the first threshold and the second standardized value is larger than a second threshold in at least one of the charging ranges.

6. The apparatus (10) for detecting a latent defective cell in a battery pack (20) according to claim 1, wherein the control unit (14) is configured to, for each of the first to N-th cells,

monitor if a relative change behavior of the second cell voltage time-series data and the predicted cell voltage time-series data as the charging range shifts corresponds to a predefined change behavior pattern for each latent defect type, and finally determine the latent defect type of any cell in which the predefined change behavior pattern is found in a reference number of times or more.

7. The apparatus (10) for detecting a latent defective cell in a battery pack (20) according to claim 6, wherein the predefined change behavior pattern is that the second cell voltage time-series data increases faster than the predicted cell voltage time-series data in the charging range at an early stage of charging and the predicted cell voltage time-series data increases faster than the second cell voltage time-series data in the charging range at a later stage of charging, and

wherein the latent defect type is a lithium plating at a negative electrode.

8. The apparatus (10) for detecting a latent defective cell in a battery pack (20) according to claim 1, further comprising:

a recording storage medium (15) configured to store data, a predefined parameter, a program or a combination thereof; and a display (16),

wherein the control unit (14) is configured to record identification information associated with the detected latent defective cell in the recording storage medium (15), or output a message notifying that the latent defective cell is detected in the battery pack through the display (16), or transmit the identification information of the latent defective cell to an external device via communication.

9. A battery management system comprising the apparatus (10) for detecting a latent defective cell in a battery pack (20) according to claim 1.

10. A method for detecting a latent defective cell in a battery pack, comprising:

during charging (S10) of the battery pack according to a charging profile having a plurality of charging ranges, for each of first to N-th cells in each charging range,

(a) acquiring (S20) first cell voltage time-series data in a former part of the charging range;

(b) determining (S30) predicted cell voltage time-series data in a latter part of the charging range by applying a deep learning model to the first cell voltage time-series data;

(c) acquiring (S20) second cell voltage time-series data in the latter part;

(d) determining (S40) an error between the second cell voltage time-series data and the predicted cell voltage time-series data; and

(e) detecting (S70) any cell having a larger error than other cells in at least one of the charging ranges as the latent defective cell.

11. The method for detecting a latent defective cell in a battery pack according to claim 10, wherein the step (d) (S40) comprises, for each of the first to N-th cells, determining a maximum difference between the second cell voltage time-series data and the predicted cell voltage time-series data as the error for each charging range, and

wherein the step (e) (S70) comprises:

(e1) determining (S50) a first average and a first standard deviation of the error of the first to N-th cells for each charging range;

(e2) determining (S60) "(the error - the first average)/the first standard deviation" corresponding to a first standardized value of the error of each of the first to N-th cells for each charging range; and

(e3) detecting any cell in which the first standardized value is larger than a first threshold in at least one of the charging ranges as the latent defective cell.

12. The method for detecting a latent defective cell in a battery pack according to claim 10, wherein the deep learning model is pre-trained, using the first cell voltage time-series data and the second cell voltage time-series data of first to m-th training cells measured in the former part and the latter part of each charging range, to receive an input of the first cell voltage time-series data and output the predicted cell voltage time-series data having a minimum error with the second cell voltage time-series data.

13. The method for detecting a latent defective cell in a battery pack according to claim 12, wherein the step (d) (S40) comprises, for each of the first to N-th cells, determining a maximum difference between the second cell voltage time-series data and the predicted cell voltage time-series data as the error for each charging range, and
wherein the step (e) (S70) comprises:

(e1) determining "(the error - a first average)/a first standard deviation" corresponding to a first standardized value of the error of each of the first to N-th cells for each charging range; and

(e2) detecting any cell in which the first standardized value is larger than a first threshold in at least one of the charging ranges as the latent defective cell, and
wherein the first average and the first standard deviation are pre-determined values in the training process of the deep learning model.

14. The method for detecting a latent defective cell in a battery pack according to claim 11 or 13, wherein the battery pack includes first to p-th modules connected in series and/or in parallel, and

wherein the method further comprises, for each of the first to p-th modules, determining (S100) a second average and a second standard deviation of the error of each of the plurality of cells included in the module;
determining (S110) "(the error - the second average)/the second standard deviation" corresponding to a second standardized value of the error of each of the first to N-th cells for each charging range; and
detecting (S120) any cell in which the first standardized value is larger than the first threshold and the second standardized value is larger than a second threshold as the latent defective cell.

15. The method for detecting a latent defective cell in a battery pack according to claim 10, further comprising:

for each of the first to N-th cells, monitoring (S130) a relative change behavior of the second cell voltage time-series data and the predicted cell voltage time-series data as the charging range shifts corresponds to a predefined change behavior pattern for each latent defect type; and
finally determining (S180) the latent defect type of any cell in which the predefined change behavior pattern is found in a reference number of times or more.

16. The method for detecting a latent defective cell in a battery pack according to claim 15, wherein the predefined change behavior pattern is that the second cell voltage time-series data increases faster than the predicted cell voltage time-series data in the charging range at an early stage of charging and the predicted cell voltage time-series data increases faster than the second cell voltage time-series data in the charging range at a later stage of charging, and
wherein the latent defect type is a lithium plating at a negative electrode.

17. The method for detecting a latent defective cell in a battery pack according to claim 10, further comprising:

recording (S80) identification information associated with the detected latent defective cell in a recording storage medium;
outputting (S90) a message notifying that the latent defective cell is detected in the battery pack through a display; or
transmitting the identification information of the latent defective cell to an external device via communication.

**Patentansprüche**

1. Vorrichtung (10) zum Detektieren einer latent defekten Zelle in einem Batteriepack (20), umfassend:

eine Spannungsmesseinheit (11), eine Strommesseinheit (12) und eine Temperaturmesseinheit (13), um eine Spannung, einen Strom bzw. eine Temperatur einer ersten bis n-ten Zelle zu messen, welche in dem Batteriepack (20) umfasst sind, während eines Ladens des Batteriepacks (20), und
eine Steuereinheit (14), welche mit der Spannungsmesseinheit (11), der Strommesseinheit (12) und der Temperaturmesseinheit (13) betriebsfähig gekoppelt ist,
wobei die Steuereinheit (14) dazu eingerichtet ist, während des Ladens des Batteriepacks (20), gemäß einem Ladeprofil, welches eine Mehrzahl von Ladebereichen aufweist, für jede der ersten bis n-ten Zellen in jedem Ladebereich, erste Zellenspannungszeitseriendaten durch die Spannungsmesseinheit (11) in einem früheren Teil des Ladebereichs zu akquirieren; vorhergesagte erste Zellenspannungszeitseriendaten in einem späteren Teil des Ladebereichs durch Anwenden eines Deep-Learning-Models auf die ersten Zellenspannungszeitseriendaten zu bestimmen; zweite Zellenspannungszeitseriendaten durch die Spannungsmesseinheit (11) in dem späteren Teil des Ladebereichs zu akquirieren; und einen Fehler zwischen den zweiten Zellenspannungszeitseriendaten und den vorhergesagten Zellenspannungszeitseriendaten zu bestimmen, und
wobei die Steuereinheit (14) ferner dazu eingerichtet ist, jede Zelle, welche einen größeren Fehler als andere Zellen aufweist, in wenigstens einem der Ladebereiche, als die latent defekte Zelle zu detektieren.

2. Vorrichtung (10) zum Detektieren einer latent defekten Zelle in einem Batteriepack (20) nach Anspruch 1, wobei die Steuereinheit (14) dazu eingerichtet ist, für jede der ersten bis n-ten Zellen, einen maximalen Unterschied zwischen den zweiten Zellenspannungszeitseriendaten und den vorhergesagten Zellenspannungszeitseriendaten als den Fehler für jeden Ladebereich zu bestimmen; einen ersten Durchschnitt und eine erste Standardabweichung des Fehlers der ersten bis n-ten Zellen für jeden Ladebereich zu bestimmen; "(der Fehler - der erste Durchschnitt)/die erste Standardabweichung" zu bestimmen, entsprechend einem ersten standardisierten Wert des Fehlers jeder der ersten bis n-ten Zellen für jeden Ladebereich, und jede Zelle, in welcher der erste standardisierte Wert größer als ein erster Schwellenwert in wenigstens einem der Ladebereiche ist, als die latent defekte Zelle zu detektieren.

3. Vorrichtung (10) zum Detektieren einer latent defekten Zelle in einem Batteriepack (20) nach Anspruch 1, wobei das Deep-Learning-Model vortrainiert ist, unter Verwendung der ersten Zellenspannungszeitseriendaten und der zweiten Zellenspannungszeitseriendaten von ersten bis m-ten Trainingszellen, welche in dem früheren Teil bzw. dem späteren Teil jedes Ladebereichs gemessen sind, um eine Eingabe der ersten Zellenspannungszeitseriendaten zu erhalten und die vorhergesagten Zellenspannungszeitseriendaten, welche einen minimalen Fehler aufweisen, mit den zweiten Zellenspannungszeitseriendaten auszugeben.

4. Vorrichtung (10) zum Detektieren einer latent defekten Zelle in einem Batteriepack (20) nach Anspruch 3, wobei die Steuereinheit (14) dazu eingerichtet ist, für jede der ersten bis n-ten Zellen, einen maximalen Unterschied zwischen den zweiten Zellenspannungszeitseriendaten und der vorhergesagten Zellenspannungszeitseriendaten als den Fehler für jeden Ladebereich zu bestimmen, "(der Fehler - einen ersten Durchschnitt)/eine erste Standardabweichung" zu bestimmen, entsprechend einem ersten standardisierten Wert des Fehlers jeder der ersten bis n-ten Zellen für jeden Ladebereich, und jede Zelle, in welcher der erste standardisierte Wert größer als ein erster Schwellenwert in wenigstens einem der Ladebereiche ist, als die latent defekte Zelle zu detektieren, und
wobei der erste Durchschnitt und die erste Standardabweichung vorbestimmte Werte in dem Trainingsprozess des Deep-Learning-Models sind.

5. Vorrichtung (10) zum Detektieren einer latent defekten Zelle in einem Batteriepack (20) nach Anspruch 2 oder 4, wobei der Batteriepack (20) erste bis p-te Module umfasst, welche in Serie und/oder parallel geschaltet sind, und wobei die Steuereinheit (14) dazu eingerichtet ist, für jedes der ersten bis p-ten Module, einen zweiten Durchschnitt und eine zweite Standardabweichung für den Fehler jeder der Mehrzahl von Zellen zu bestimmen, welche in dem Modul umfasst sind; und "(der Fehler - der zweite Durchschnitt)/die zweite Standardabweichung" zu bestimmen, entsprechend einem zweiten standardisierten Wert des Fehlers jeder der ersten bis n-ten Zellen für jeden Ladebereich, und, als die latent defekte Zelle, jede Batteriezelle zu detektieren, in welcher der erste standardisierte Wert größer als der erste Schwellenwert ist und der zweite standardisierte Wert größer als ein zweiter Schwellenwert ist, in wenigstens einem der Ladebereiche.

6. Vorrichtung (10) zum Detektieren einer latent defekten Zelle in einem Batteriepack (20) nach Anspruch 1, wobei die Steuereinheit (14) dazu eingerichtet ist, für jede der ersten bis n-ten Zellen, zu überwachen, ob ein relatives Änderungsverhalten der zweiten Zellenspannungszeitseriendaten und der vorhergesagten Zellenspannungszeitseriendaten als die Ladebereichverschiebungen einem vordefinierten Änderungsverhaltensmuster für jeden latent defekten Typ entspricht, und letztendlich den latent defekten Typ jeder Zelle zu bestimmen, in welcher das vordefinierte Änderungsverhaltensmuster in einer Referenzanzahl von Wiederholungen oder mehr gefunden ist.

7. Vorrichtung (10) zum Detektieren einer latent defekten Zelle in einem Batteriepack (20) nach Anspruch 6, wobei das vordefinierte Änderungsverhaltensmuster ist, dass sich die zweiten Zellenspannungszeitseriendaten schneller als die vorgesagten Zellenspannungszeitseriendaten in dem Ladebereich in einem früheren Stadium eines Ladens erhöhen und sich die vorhergesagten Zellenspannungszeitseriendaten schneller als die zweiten Zellenspannungszeitseriendaten in dem Ladebereich in einem späteren Stadium eines Ladens erhöhen, und
wobei der latent defekte Typ eine Lithiumplattierung an einer negativen Elektrode ist.

8. Vorrichtung (10) zum Detektieren einer latent defekten Zelle in einem Batteriepack (20) nach Anspruch 1, ferner umfassend:

   ein Aufnahmespeichermedium (15), welches dazu eingerichtet ist, Daten, einen vordefinierten Parameter, ein Programm oder eine Kombination davon zu speichern; und eine Anzeige (16),
   wobei die Steuereinheit (14) dazu eingerichtet ist, Identifikationsinformationen, welche mit der detektierten latent defekten Zelle assoziiert sind, in dem Aufnahmespeichermedium (15) aufzunehmen, oder eine Nachricht, welche benachrichtigt, dass die latent defekte Zelle in dem Batteriepack detektiert ist, durch die Ausgabe (16) auszugeben, oder die Identifikationsinformationen der latent defekten Zelle zu einer externen Vorrichtung mittels Kommunikation zu übertragen.

9. Batterieverwaltungssystem, umfassend die Vorrichtung (10) zum Detektieren einer latent defekten Zelle in einem Batteriepack (20) nach Anspruch 1.

10. Verfahren zum Detektieren einer latent defekten Zelle in einem Batteriepack, umfassend:
während eines Ladens (S10) des Batteriepacks, gemäß einem Ladeprofil, welches eine Mehrzahl von Ladebereichen aufweist, für jede der ersten bis n-ten Zellen in jedem Ladebereich,

   (a) Akquirieren (S20) erster Zellenspannungszeitseriendaten in einem früheren Teil des Ladebereichs;
   (b) Bestimmen (S30) vorhergesagter Zellenspannungszeitseriendaten in einem späteren Teil des Ladebereichs durch Anwenden eines Deep-Learning-Models auf die ersten Zellenspannungszeitseriendaten;
   (c) Akquirieren (S20) zweiter Zellenspannungszeitseriendaten in dem späteren Teil;
   (d) Bestimmen (S40) eines Fehlers zwischen den zweiten Zellenspannungszeitseriendaten und den vorhergesagten Zellenspannungszeitseriendaten; und
   (e) Detektieren (S70) jeder Zelle, welche einen größeren Fehler als andere Zellen aufweist, in wenigstens einem der Ladebereiche, als die latent defekte Zelle.

11. Verfahren zum Detektieren einer latent defekten Zelle in einem Batteriepack nach Anspruch 10, wobei der Schritt (d) (S40) umfasst, für jede der ersten bis n-ten Zellen, Bestimmen eines maximalen Unterschieds zwischen den zweiten Zellenspannungszeitseriendaten und den vorhergesagten Zellenspannungszeitseriendaten als den Fehler für jeden Ladebereich; und
wobei der Schritt (e) (S70) umfasst:

   (e1) Bestimmen (S50) eines ersten Durchschnitts und einer ersten Standardabweichung des Fehlers der ersten bis n-ten Zellen für jeden Ladebereich;
   (e2) Bestimmen (S60) von "(der Fehler - der erste Durchschnitt)/die erste Standardabweichung", entsprechend einem ersten standardisierten Wert des Fehlers jeder der ersten bis n-ten Zellen für jeden Ladebereich, und
   (e3) Detektieren jeder Zelle, in welcher der erste standardisierte Wert größer als ein erster Schwellenwert in wenigstens einem der Ladebereiche ist, als die latent defekte Zelle.

12. Verfahren zum Detektieren einer latent defekten Zelle in einem Batteriepack nach Anspruch 10, wobei das Deep-Learning-Model vortrainiert ist, unter Verwendung der ersten Zellenspannungszeitseriendaten und der zweiten Zellenspannungszeitseriendaten von ersten bis m-ten Trainingszellen, welche in dem früheren Teil und dem späteren Teil jedes Ladebereichs gemessen werden, um eine Eingabe der ersten Zellenspannungszeitseriendaten zu erhalten und die vorhergesagten Zellenspannungszeitseriendaten, welche einen minimalen Fehler aufweisen, mit den zweiten Zellenspannungszeitseriendaten auszugeben.

**13.** Verfahren zum Detektieren einer latent defekten Zelle in einem Batteriepack nach Anspruch 12, wobei der Schritt (d) (S40) umfasst, für jede der ersten bis n-ten Zellen, Bestimmen eines maximalen Unterschieds zwischen den zweiten Zellenspannungszeitseriendaten und der vorhergesagten Zellenspannungszeitseriendaten als den Fehler für jeden Ladebereich; und

wobei der Schritt (e) (S70) umfasst:

(e1) Bestimmen von "(der Fehler - ein erster Durchschnitt)/eine erste Standardabweichung", entsprechend einem ersten standardisierten Wert des Fehlers jeder der ersten bis n-ten Zellen für jeden Ladebereich, und
(e2) Detektieren jeder Zelle, in welcher der erste standardisierte Wert größer als ein erster Schwellenwert in wenigstens einem der Ladebereiche ist, als die latent defekte Zelle, und
wobei der erste Durchschnitt und die erste Standardabweichung vorbestimmte Werte in dem Trainingsprozess des Deep-Learning-Models sind.

**14.** Verfahren zum Detektieren einer latent defekten Zelle in einem Batteriepack nach Anspruch 11 oder 13, wobei der Batteriepack erste bis p-te Module umfasst, welche in Serie und/oder parallel geschaltet sind, und

wobei das Verfahren ferner umfasst, für jedes der ersten bis p-ten Module, Bestimmen (S100) eines zweiten Durchschnitts und einer zweiten Standardabweichung für den Fehler jeder der Mehrzahl von Zellen, welche in dem Modul umfasst sind;
Bestimmen (S110) von "(der Fehler - der zweite Durchschnitt)/die zweite Standardabweichung", entsprechend einem zweiten standardisierten Wert des Fehlers jeder der ersten bis n-ten Zellen für jeden Ladebereich, und
Detektieren (S120) jeder Zelle, in welcher der erste standardisierte Wert größer als der erste Schwellenwert ist und der zweite standardisierte Wert größer als ein zweiter Schwellenwert ist, als die latent defekte Zelle.

**15.** Verfahren zum Detektieren einer latent defekten Zelle in einem Batteriepack nach Anspruch 10, ferner umfassend:

für jede der ersten bis n-ten Zellen, Überwachen (S130) eines relativen Änderungsverhaltens der zweiten Zellenspannungszeitseriendaten und der vorhergesagten Zellenspannungszeitseriendaten, wenn die Ladebereichverschiebungen einem vordefinierten Änderungsverhaltensmuster für jeden latent defekten Typ entspricht; und
letztendlich Bestimmen (S180) des latent defekten Typs jeder Zelle, in welcher das vordefinierte Änderungsverhaltensmuster in einer Referenzanzahl von Wiederholungen oder mehr gefunden wird.

**16.** Verfahren zum Detektieren einer latent defekten Zelle in einem Batteriepack nach Anspruch 15, wobei das vordefinierte Änderungsverhaltensmuster ist, dass sich die zweiten Zellenspannungszeitseriendaten schneller als die vorgesagten Zellenspannungszeitseriendaten in dem Ladebereich in einem früheren Stadium eines Ladens erhöhen und sich die vorhergesagten Zellenspannungszeitseriendaten schneller als die zweiten Zellenspannungszeitseriendaten in dem Ladebereich in einem späteren Stadium eines Ladens erhöhen, und wobei der latent defekte Typ eine Lithiumplattierung an einer negativen Elektrode ist.

**17.** Verfahren zum Detektieren einer latent defekten Zelle in einem Batteriepack nach Anspruch 10, ferner umfassend:

Aufnehmen (S80) von Identifikationsinformationen, welche mit der detektierten latent defekten Zelle assoziiert werden, in einem Aufnahmespeichermedium;
Ausgeben (S90) einer Nachricht, welche benachrichtigt, dass die latent defekte Zelle in dem Batteriepack detektiert wird, durch eine Ausgabe, oder
Übertragen der Identifikationsinformationen der latent defekten Zelle zu einer externen Vorrichtung mittels Kommunikation.

**Revendications**

**1.** Appareil (10) de détection d'une cellule défectueuse latente dans un bloc-batterie (20), comprenant :

une unité de mesure de tension (11), une unité de mesure de courant (12) et une unité de mesure de température (13) pour mesurer une tension, un courant et une température des première à N-ième cellules incluses dans le bloc-batterie (20) pendant la charge du bloc-batterie (20), respectivement, et
une unité de commande (14) couplée de manière fonctionnelle à l'unité de mesure de tension (11), à l'unité de mesure de courant (12) et à l'unité de mesure de température (13),

dans lequel l'unité de commande (14) est configurée pour, pendant la charge du bloc-batterie (20) selon un profil de charge ayant une pluralité de plages de charge, pour chacune des première à N-ième cellules dans chaque plage de charge, acquérir des premières données de tension de cellule en série temporelle par l'intermédiaire de l'unité de mesure de tension (11) dans une première partie de la plage de charge ; déterminer des données de tension de cellule en série temporelle prédites dans une dernière partie de la plage de charge en appliquant un modèle d'apprentissage profond aux premières données de tension de cellule en série temporelle ; acquérir des secondes données de tension de cellule en série temporelle par l'intermédiaire de l'unité de mesure de tension (11) dans la dernière partie de la plage de charge, et déterminer une erreur entre les secondes données de tension de cellule en série temporelle et les données de tension de cellule en série temporelle prédites, et

dans lequel l'unité de commande (14) est en outre configurée pour détecter toute cellule présentant une erreur plus importante que d'autres cellules dans au moins l'une des plages de charge en tant que cellule défectueuse latente.

2. Appareil (10) de détection d'une cellule défectueuse latente dans un bloc-batterie (20) selon la revendication 1, dans lequel l'unité de commande (14) est configurée pour, pour chacune des premières à N-ième cellules, déterminer une différence maximale entre les secondes données de tension de cellule en série temporelle et les données de tension de cellule en série temporelle prédites comme l'erreur pour chaque plage de charge ; déterminer une première moyenne et un premier écart-type de l'erreur des premières à N-ième cellules pour chaque plage de charge ; déterminer « (l'erreur - la première moyenne)/le premier écart-type » correspondant à une première valeur normalisée de l'erreur de chacune des première à N-ième cellules pour chaque plage de charge, et détecter toute cellule dans laquelle la première valeur normalisée est supérieure à un premier seuil dans au moins une des plages de charge en tant que cellule défectueuse latente.

3. Appareil (10) de détection d'une cellule défectueuse latente dans un bloc-batterie (20) selon la revendication 1, dans lequel le modèle d'apprentissage profond est préentraîné, en utilisant les premières données de tension de cellule en série temporelle et les secondes données de tension de cellule en série temporelle de première à m-ième cellules d'entraînement mesurées respectivement dans la première partie et la dernière partie de chaque plage de charge, pour recevoir une entrée des première données de tension de cellule en série temporelle et délivrer les données de tension de cellule en série temporelle prédites ayant une erreur minimale avec les secondes données de tension de cellule en série temporelle.

4. Appareil (10) de détection d'une cellule défectueuse latente dans un bloc-batterie (20) selon la revendication 3, dans lequel l'unité de commande (14) est configurée pour, pour chacune des première à N-ième cellules, déterminer une différence maximale entre les secondes données de tension de cellule en série temporelle et les données de tension de cellule en série temporelle prédites comme l'erreur pour chaque plage de charge ; déterminer « (l'erreur - une première moyenne)/un premier écart-type » correspondant à une première valeur normalisée de l'erreur de chacune des première à N-ième cellules pour chaque plage de charge, et détecter toute cellule dans laquelle la première valeur normalisée est supérieure à un premier seuil dans au moins l'une des plages de charge en tant que cellule défectueuse latente, et

dans lequel la première moyenne et le premier écart-type sont des valeurs prédéterminées dans le procédé d'entraînement du modèle d'apprentissage profond.

5. Appareil (10) de détection d'une cellule défectueuse latente dans un bloc-batterie (20) selon la revendication 2 ou 4, dans lequel le bloc-batterie (20) comporte des premier à p-ième modules connectés en série et/ou en parallèle, et dans lequel l'unité de commande (14) est configurée pour, pour chacun des premier à p-ième modules, déterminer une seconde moyenne et un second écart-type de l'erreur de chacune de la pluralité de cellules incluses dans le module ; et déterminer « (l'erreur - la seconde moyenne)/le second écart-type » correspondant à une seconde valeur normalisée de l'erreur de chacune des première à N-ième cellules pour chaque plage de charge, et détecter, en tant que cellule défectueuse latente, toute cellule de batterie dans laquelle la première valeur normalisée est supérieure au premier seuil et la seconde valeur normalisée est supérieure à un second seuil dans au moins une des plages de charge.

6. Appareil (10) de détection d'une cellule défectueuse latente dans un bloc-batterie (20) selon la revendication 1, dans lequel l'unité de commande (14) est configurée pour, pour chacune des première à N-ième cellules,

surveiller si un comportement de changement relatif des secondes données de tension de cellule en série temporelle et des données de tension de cellule en série temporelle prédites lorsque la plage de charge change correspond à un profil de comportement de changement prédéfini pour chaque type de défaut latent, et finalement déterminer le type de défaut latent de toute cellule dans laquelle le profil de comportement de changement prédéfini est trouvé un nombre de fois de référence ou plus.

7. Appareil (10) de détection d'une cellule défectueuse latente dans un bloc-batterie (20) selon la revendication 6, dans lequel le profil de comportement de changement prédéfini est que les secondes données de tension de cellule en série temporelle augmentent plus rapidement que les données de tension de cellule en série temporelle prédites dans la plage de charge à un stade précoce de charge et que les données de tension de cellule en série temporelle prédites augmentent plus rapidement que les secondes données de tension de cellule en série temporelle dans la plage de charge à un stade ultérieur de charge, et

dans lequel le type de défaut latent est un placage de lithium au niveau d'une électrode négative.

8. Appareil (10) de détection d'une cellule défectueuse latente dans un bloc-batterie (20) selon la revendication 1, comprenant en outre:

un support de stockage d'enregistrement (15) configuré pour stocker des données, un paramètre prédéfini, un programme ou une combinaison de ceux-ci ; et un affichage (16),
dans lequel l'unité de commande (14) est configurée pour enregistrer des informations d'identification associées à la cellule défectueuse latente détectée dans le support de stockage d'enregistrement (15), ou délivrer un message indiquant que la cellule défectueuse latente est détecté dans le bloc-batterie par l'intermédiaire de l'affichage (16), ou transmettre les informations d'identification de la cellule défectueuse latente à un dispositif externe par communication.

9. Système de gestion de batterie comprenant l'appareil (10) de détection d'une cellule défectueuse latente dans un bloc-batterie (20) selon la revendication 1.

10. Procédé de détection d'une cellule défectueuse latente dans un bloc-batterie, comprenant :
lors d'une charge (S10) du bloc-batterie selon un profil de charge ayant une pluralité de plages de charge, pour chacune des première à N-ième cellules dans chaque plage de charge,

(a) une acquisition (S20) de premières données de tension de cellule en série temporelle dans une première partie de la plage de charge ;
(b) une détermination (S30) de données de tension de cellule en série temporelle prédites dans une dernière partie de la plage de charge en appliquant un modèle d'apprentissage profond aux premières données de tension de cellule en série temporelle ;
(c) une acquisition (S20) de secondes données de tension de cellule en série temporelle dans cette dernière partie ;
(d) une détermination (S40) d'une erreur entre les secondes données de tension de cellule en série temporelle et les données de tension de cellule en série temporelle prédites ; et
(e) une détection (S70) de toute cellule présentant une erreur plus importante que d'autres cellules dans au moins l'une des plages de charge en tant que cellule défectueuse latente.

11. Procédé de détection d'une cellule défectueuse latente dans un bloc-batterie selon la revendication 10, dans lequel l'étape (d) (S40) comprend, pour chacune des premières à N-ième cellules, une détermination d'une différence maximale entre les secondes données de tension de cellule en série temporelle et les données de tension de cellule en série temporelle prédites comme l'erreur pour chaque plage de charge, et dans lequel l'étape (e) (S70) comprend :

(e1) une détermination (S50) d'une première moyenne et d'un premier écart-type de l'erreur des première à N-ième cellules pour chaque plage de charge ;
(e2) une détermination (S60) de « (l'erreur - la première moyenne)/le premier écart-type » correspondant à une première valeur normalisée de l'erreur de chacune des première à N-ième cellules pour chaque plage de charge ; et
(e3) une détection de toute cellule dans laquelle la première valeur normalisée est supérieure à un premier seuil dans au moins l'une des plages de charge en tant que cellule défectueuse latente.

12. Procédé de détection d'une cellule défectueuse latente dans un bloc-batterie selon la revendication 10, dans lequel le modèle d'apprentissage profond est préentraîné, en utilisant les premières données de tension de cellule en série temporelle et les secondes données de tension de cellule en série temporelle de première à m-ième cellules d'entraînement mesurées dans la première partie et la dernière partie de chaque plage de charge, pour recevoir une entrée des première données de tension de cellule en série temporelle et délivrer les données de tension de cellule en série temporelle prédites ayant une erreur minimale avec les secondes données de tension de cellule en série temporelle.

13. Procédé de détection d'une cellule défectueuse latente dans un bloc-batterie selon la revendication 12, dans lequel l'étape (d) (S40) comprend, pour chacune des premières à N-ième cellules, une détermination d'une différence maximale entre les secondes données de tension de cellule en série temporelle et les données de tension de cellule en série temporelle prédites comme l'erreur pour chaque plage de charge, et dans lequel l'étape (e) (S70) comprend :

(e1) une détermination de « (l'erreur - une première moyenne)/un premier écart-type » correspondant à une première valeur normalisée de l'erreur de chacune des première à N-ième cellules pour chaque plage de charge ; et
(e2) une détection de toute cellule dans laquelle la première valeur normalisée est supérieure à un premier seuil dans au moins l'une des plages de charge en tant que cellule défectueuse latente, et
dans lequel la première moyenne et le premier écart-type sont des valeurs prédéterminées dans le procédé d'entraînement du modèle d'apprentissage profond.

14. Procédé de détection d'une cellule défectueuse latente dans un bloc-batterie selon la revendication 11 ou 13, dans lequel le bloc-batterie comporte des premier à p-ième modules connectés en série et/ou en parallèle, et

dans lequel le procédé comprend en outre, pour chacun des premier à p-ième modules, une détermination (S100) d'une seconde moyenne et d'un second écart-type de l'erreur de chacune de la pluralité de cellules incluses dans le module ;
une détermination (S110) de « (l'erreur - la seconde moyenne)/le second écart-type » correspondant à une seconde valeur normalisée de l'erreur de chacune des première à N-ième cellules pour chaque plage de charge ; et
une détection (S120) de toute cellule dans laquelle la première valeur normalisée est supérieure au premier seuil et la seconde valeur normalisée est supérieure à un second seuil en tant que cellule défectueuse latente.

15. Procédé de détection d'une cellule défectueuse latente dans un bloc-batterie selon la revendication 10, comprenant en outre :

pour chacune des première à N-ième cellules, une surveillance (S130) qu'un comportement de changement relatif des secondes données de tension de cellule en série temporelle et des données de tension de cellule en série temporelle prédites lorsque la plage de charge change correspond à un profil de comportement de changement prédéfini pour chaque type de défaut latent ; et
finalement une détermination (S180) du type de défaut latent de toute cellule dans laquelle le profil de comportement de changement prédéfini est trouvé un nombre de fois de référence ou plus.

16. Procédé de détection d'une cellule défectueuse latente dans un bloc-batterie selon la revendication 15, dans lequel le profil de comportement de changement prédéfini est que les secondes données de tension de cellule en série temporelle augmentent plus rapidement que les données de tension de cellule en série temporelle prédites dans la plage de charge à un stade précoce de charge et que les données de tension de cellule en série temporelle prédites augmentent plus rapidement que les secondes données de tension de cellule en série temporelle dans la plage de charge à un stade ultérieur de charge, et
dans lequel le type de défaut latent est un placage de lithium au niveau d'une électrode négative.

17. Procédé de détection d'une cellule défectueuse latente dans un bloc-batterie selon la revendication 10, comprenant en outre :

un enregistrement (S80) d'informations d'identification associées à la cellule défectueuse latente détectée dans un support de stockage d'enregistrement ;
une sortie (S90) d'un message indiquant que la cellule défectueuse latente est détectée dans le bloc-batterie par l'intermédiaire d'un affichage ; ou
une transmission des informations d'identification de la cellule défectueuse latente à un dispositif externe par communication.

FIG. 1

EP 4 321 884 B1

FIG. 2

FIG. 3

FIG. 4

FIG. 5

First cell voltage time-series data

Second cell voltage time-series data

FIG. 6

FIG. 7

FIG. 8

Charging device(30) applies charging current to battery pack(20) according to charging profile including a plurality of charging ranges ~S10

Acquire first and second cell voltage time-series data of each cell by periodically receiving input of cell voltage value from voltage measurement unit(11) in each charging range during charging of battery pack(20) ~S20

Determine predicted cell voltage time-series data in latter part of charging range by applying deep learning model to first cell voltage time-series data in each charging range ~S30

Calculate error $E_{k,i}$ between second cell voltage time-series data and predicted cell voltage time-series data of first to N-th cells using Equation 1 for each charging range ~S40

Determine first average $Avr_k$ and first standard deviation $\sigma_k$ of error $E_{k,i}$ of first to N-th cells for each charging range ~S50

Determine first standardized value $Std\_Value_{k,i}$ of error $E_{k,i}$ of each of first to N-th cells using Equation 3 for each charging range ~S60

Detect, as latent defective cell, any cell in which first standardized value $Std\_Value_{k,i}$ is larger than preset first threshold in at least one charging range ~S70

(A)

Record identification information of latent defective cell and/or information associated with latent defect type in recording storage medium (15) together with time stamp ~S80

Output message notifying that latent defective cell is detected in battery pack(20) through display(16) ~S90

FIG. 9

```
┌──────────────────────────────────────────────────────┐
│   Determine second average Avr_{k,a} and second       │
│   standard deviation σ_{k,a} of error E_{k,i} for     │  ~S100
│   each module using Equation 4                         │
└──────────────────────────────────────────────────────┘
                          │
                          ▼
┌──────────────────────────────────────────────────────┐
│   Determine second standardized value Std_Value*_{k,i} in │
│   module for error E_{k,i} of each of first to N-th cells for │  ~S110
│   each charging range using Equation 5                 │
└──────────────────────────────────────────────────────┘
                          │
                          ▼
┌──────────────────────────────────────────────────────┐
│   Detect, as latent defective cell, any cell in which first │
│   standardized value Std_Value_{k,i} is larger than first │
│   threshold and second standardized value Std_Value*_{k,i} in │  ~S120
│   module is larger than second threshold in at         │
│   least one charging range                             │
└──────────────────────────────────────────────────────┘
                          │
                          ▼
                        ( A )
```

FIG. 10

Monitor if relative change behavior of second
cell voltage time-series data of first to N-th
cells and predicted cell voltage time-series
data shows predefined change behavior pattern for
each latent defect type by shift of charging range ~S130

S140

No ◇ Does it correspond to
predefined change behavior
pattern? ◇

Yes

Identify latent defect type (e.g., lithium
plating at negative electrode) corresponding to ~S150
predefined change behavior pattern

Increase latent defect count of cell for which ~S160
latent defect type is identified by 1

S170

No ◇ Does latent defect
count exceed reference number
of times? ◇

Yes

Finally determine latent defect type (e.g.,
lithium plating at negative electrode) of ~S180
the corresponding cell

Ⓐ

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2020081070 A1